# EUROPEAN PATENT SPECIFICATION

(11) **EP 0 403 822 B1**
(45) Date of publication and mention of the grant of the patent: **12.10.1994**
(21) Application number: 90109885.5
(22) Date of filing: 23.05.1990
(51) Int. Cl.: G11C 16/06

(54) **Circuit and method for conditioning erased eeproms prior to programming**
Schaltung und Verfahren zur Vorbereitung gelöschter EEPROMS vor der Programmierung
Circuit et procédé pour le conditionnement d'EEPROMS remis à zéro avant la programmation

(30) Priority: 19.06.1989 US 367597
(43) Date of publication of application: 27.12.1990
(73) Proprietor: TEXAS INSTRUMENTS INCORPORATED, Dallas Texas 75265 (US)
(72) Inventor: McElroy, David J, Rosenberg Texas 77471 (US)
(74) Representative: Leiser, Gottfried, Dipl.-Ing.

(56) References cited:
- GB-A- 2 028 615
- GB-A- 2 029 145

## Description

### BACKGROUND OF THE INVENTION

This invention relates to an EEPROM as indicated in the preambles of claims 1, 13, 15 are apparent from GB-A-2 028 615. In particular, it relates to a circuit for, and a method for, conditioning erased EEPROMs of the single-transistor type prior to applying electrical programming pulses. The electrical conditioning pulses compress the range of threshold voltages, the range resulting from erasure of the programming charges stored on floating gates of electrically-erasable, electrically-programmable read-only-memories (EEPROMs). The compressed range of erased threshold voltages permits more reliable operation of the EEPROM array after subsequent programming.

EEPROM arrays are comprised of rows and columns of floating gate memory cells. Each column and row may contain hundreds of cells, all of the cells in each column having source-drain paths connected in parallel by bitlines and all of the control gates in each row connected to a wordline. Prior to first programming, or perhaps after erasure by ultraviolet light, the source-drain paths of the cells have a uniform voltage threshold Vt, perhaps 2.5 volts, because the floating gates are neutrally charged (having neither an excess of electrons nor a deficiency of electrons). That uniform threshold voltage may be increased or decreased by doping the channel region during manufacture. After programming, the source-drain paths of the programmed cells have voltage thresholds Vt distributed over a range of perhaps +6 volts to +9 volts. The distribution of threshold voltages among individual cells is caused by processing variations, including variations in thicknesses of tunnelling regions and variations in coupling ratios of the control-gate voltages to the floating gates.

After electrical erasure of all of the cells, the threshold voltages Vt may be distributed over a perhaps 2-volt range, the upper and lower voltage values of the range depending on the strength of the erasing pulses. Using a lower-strength erasing pulses, the range may be from perhaps +1.5 to +3.5 volts with the majority of the cells having erased threshold voltages Vt near +2.5 volts. With higher-strength erasing pulses applied, the distribution may range from perhaps 0 to +1.5 volts with the majority of cells having erased threshold voltages Vt less than +1.0 volt. Cells with erased threshold voltages less than that set during the manufacturing process have deficiencies of electrons, or positive charges, on their floating gates. The positive charges cause the channel regions under such gates to be enhanced with electrons. As defined herein, an erased threshold voltage of zero or negative value represents a cell which is conductive with no voltage applied to its control gate.

One of the problems associated with EEPROMs of the type without split gates is the difficulty of reading memory arrays after some of the cells have been over-erased. Because the channel regions of the over-erased cells are in parallel with all of the source-drain paths of other cells in a columns, inaccuracies during reading operation may occur where the stored data in those columns is short-circuited by the over-erased cells, which may be conductive because of positive charge enhancement.

The problems of over-erasure may be avoided by constructing cells with pass gates, or split gates, in which the channel between source and drain comprises two series sections, one section having the control gate separated from the channel region by the gate dielectric, the second region having the floating gate separated from the channel region by the gate dielectric. However, such memory cells require more area on a silicon chip than do cells without split gates.

The problem of over-erasure may also be minimized by performing multiple erasing operations, each operation increasing the erasing energy applied to the floating gate. Between each operation, the voltage thresholds of all of the cells may be checked to see that a given maximum voltage threshold is not exceeded. However, that procedure does not provide correction for any cells that may be over-erased.

Alternatively, a similar procedure may be used to check between increased-energy erasing pulses to determine that the minimum erased threshold voltage does not become less than some value greater than zero. However, this does not always guarantee that the highest erased voltage threshold is low enough. The highest erased voltage threshold will determine the speed at which the memory will operate.

Consequently, there is a need for a circuit and a method to improve the erased voltage threshold distribution of individual memory arrays prior to programming in order to minimize the required cell area in an integrated-circuit non-volatile memory array without sacrificing performance due to excessively high or low threshold voltages.

### SUMMARY OF THE INVENTION

The circuit and method of this invention are specified in claims 1, 13, 15. They provide for erasure of the cells of a memory array, then for application of relatively low-energy conditioning pulses to the floating gates of the cells prior to programming the array.

The circuit and method of this invention utilize the fact that the same cells that tend to erase easily (those cells having low erased threshold voltages) also tend to charge with lower energy programming pulses. Such cells may, for example, either have a thinner dielectric between floating gate and substrate or have a higher cling ratio of the control gate voltage to the floating gate. Therefore, a low-energy programming pulse will move the lower voltage thresholds through a greater increment of voltage, thereby compacting the voltage threshold distribution.

In addition, the circuit and method of this invention utilize the fact that those cells having higher programmed threshold voltages also tend to have more electrons trapped within their surfaces. Therefore, the gates of such cells are at a higher negative potential with respect to cell sources, for example, and require erasing pulses of comparatively less energy to cause electrons to channel or tunnel to those sources.

Narrowing, or compressing, the voltage threshold distribution is achieved by applying "soft" programming and/or erasing pulses. Where both types of pulses are used, each successive reversal of pulses may have a different energy than that of the previously applied pulses of the same type.

### BRIEF DESCRIPTION OF THE DRAWINGS

The novel features of this invention are set forth in the appended claims. The invention, its features, and its advantages are described below in conjunction with the following drawings:

Figure 1 is a representation of an array of memory cells and associated circuitry according to this invention.

Figure 2(a) illustrates a possible distribution of threshold voltages of an array of memory cells after manufacture or after ultraviolet-type of erasure and before programming and illustrates a possible distribution of threshold voltages after programming.

Figure 2(b) illustrates example distributions of threshold voltages of the array of memory cells after erasure.

Figure 2(c) illustrates example distributions of the erased threshold voltages of the array of memory cells after conditioning using the procedures and circuitry of this invention.

### DETAILED DESCRIPTION OF THE SPECIFIC EMBODIMENT

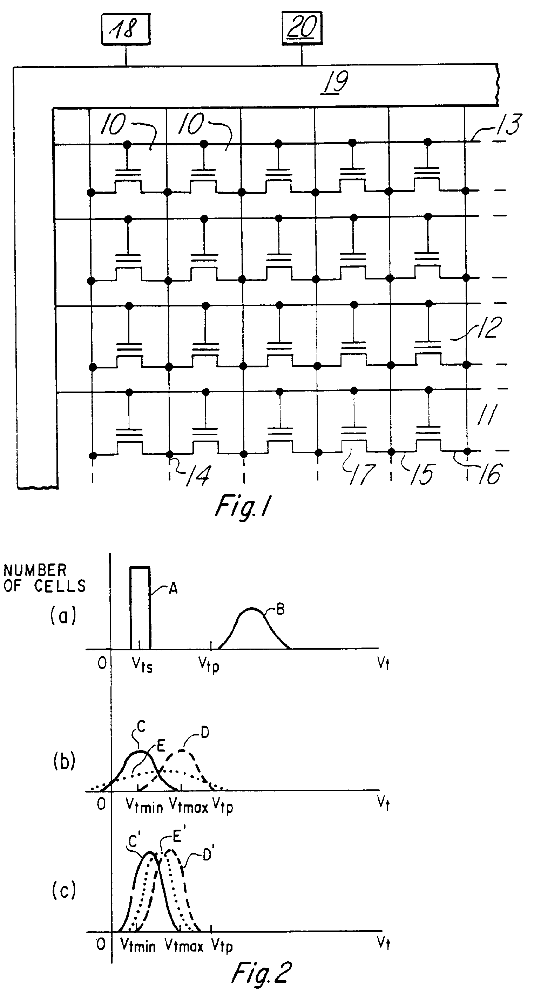

Referring to Figure 1, an electrically-programmable, electrically-erasable, read-only-memory (EEPROM) array is shown. Cells 10 include a charge-storage means, illustrated as a floating gate 11. The control gates 12 of each cell 10 in a row are connected to wordlines 13. The cells 10 are presumed to be of the type that does not include a split gate, or a pass gate. The cells 10 of Figure 1 are shown connected in a virtual-ground type of array, although this invention applies equally to cells 10 that are connected with separate bitlines 14 for each column of sources 15 and each column of drains 16. The source-drain paths, including the channel regions 17, of each cell 10 in a column are connected in parallel. Because of the parallel connection, a conductive cell 10 in that column will short-circuit all of the other cells 10 in that column. In particular, if one of the cells 10 in a column is over-erased, the channel region 17 will be enhanced with electrons attracted by the positively charged floating gate 11, and the cell 10 will be conductive with minimal volts applied to its source-drain path. A column of cells 10 that is short-circuited by one or more over-erased cells 10 is difficult, perhaps impossible, to read if the cell is constructed without a pass gate.

Programming of cells 10 is accomplished by programming circuit means 18, which is connected to wordlines 13 and bitlines 14 of the array through peripheral circuitry 19. Peripheral circuitry 19 includes logic circuitry for connecting various inputs and outputs to the wordlines and bitlines of the array. Programming circuit means 18 and peripheral circuitry 19 cause pulsed programming electric fields adjacent surfaces or parts of the floating gates of the memory cells 10 of the EEPROM array, the electric fields directed away from the surfaces or parts of the floating gates. As illustrated by curve A of Figure 2(a), the cells 10 of an array have, in general, a uniform initial threshold voltage Vts prior to programming of those cells 10. After programming, as illustrated by curve B of Figure 2(a), the cells 10 have distributed voltage thresholds Vt above a minimum programmed voltage threshold Vtp, the distribution being caused by random processing variations. For example, some of the cells 10 may have thinner dielectrics, perhaps resulting from a process that is location dependent. Other cells 10 may have smaller-area channel regions 17, perhaps because of variations in masking size. The programmed threshold voltage distribution B is illustrated as a Gaussian or bell-shaped distribution in Figure 2(a), although actual distributions have a variety of shapes depending on particular types of processing variations.

Prior to programming, cells 10 are erased by erasing circuit means 20, which is connected to wordlines 13 and bitlines 14 of the array by peripheral circuitry 19. Erasing circuit means 20 and peripheral circuitry 19 cause pulsed electric fields adjacent a surface or part of each or the floating gates of the memory cells 10 of the EEPROM array, the electric fields directed toward the surface or part of each floating gate. Erasure of the cells 10 of the same array will also result in distributed threshold voltages, caused both by processing variations and by programming voltage variations. Example distributions of erased threshold voltages are shown in Figure 2(b) as a bell-shaped curves, even though actual distributions will not necessarily have that shape.

Curve C of Figure 2(b) illustrates a prior-art type of erased voltage threshold distribution in which the cells are tested between application of erasing pulses of different energy levels until all of the cells have voltage thresholds below a prescribed maximum threshold voltage Vtmax. A disadvantage of the prior-art method is that some of the cells may be over-erased in order to achieve the maximum threshold limitation, Vtmax.

Curve D of Figure 2(b) illustrates a type of erased voltage threshold distribution in which cells 10 are tested between application of erasing pulses of different energy levels until all of the cells 10 have voltage thresholds above a prescribed minimum threshold voltage Vtmin. A disadvantage of this method is that some of the cells 10 may have threshold voltages that exceed the minimum programmed threshold voltage Vtp.

Curve E of Figure 2(b) illustrates an extreme type of erased voltage threshold distribution in which some of the cells 10 are over-erased and in which some of the cells 10 remain programmed.

In accordance with this invention, the magnitudes of the erased threshold voltages are adjusted by programming circuit means 18, and perhaps also by erasing circuit means 20, to result in a compressed distribution of threshold voltages. The mean threshold voltage may be different than the initial threshold voltage Vts set during processing by doping of the channel regions. As illustrated by curve C′ of Figure 2(c), application of low-energy pulsed conditioning electric fields by programming circuit means 18 has changed the erased voltage distribution of curve C of Figure 2(b), increasing the threshold voltages of cells with enhanced channels 17 and with lower threshold voltages to result in a more compact erased threshold voltage distribution. As discussed above, the shape of curve C′ may, in practice, different from the illustrated bell shape. The conditioning pulses are generally applied between the wordlines 13 and bitlines 14 of the array and result in pulsed conditioning electric fields that are directed away from a surface or part of each floating gate 11.

Similarly, as illustrated by curve D′ of Figure 2(c), application of low-energy pulsed conditioning electric fields by erasing circuit means 20 has changed the erased voltage distribution of curve D of Figure 2(b), decreasing the threshold voltages of programmed cells and of cells with higher erased threshold voltages to result in a more compact erased threshold voltage distribution. The conditioning pulses are generally applied between the wordlines 13 and bitlines 14 of the array and result in pulsed conditioning electric fields that are directed toward a surface or part of each floating gate 11 of the array.

As illustrated by curve E′ of Figure 2(c), application of alternating low-energy conditioning pulses by programming circuit means 18 and by erasing circuit means 20, in either order, has changed the erased voltage distribution of curve E of Figure 2(b) to a compact shape that has eliminated both programmed and over-erased cells 10.

The relatively low-energy conditioning pulses applied between wordlines 13 and bitlines 14 may have a voltage, or a current, that is perhaps 90% or less of that normally used to program all of the cells 10 of the array to a voltage threshold above Vtp. For example, if the voltage of the pulses normally used to program, or erase, the cells 10 of the array is +20 volts, conditioning voltage pulses of perhaps +15 volts might be applied to the control gates 12 of all of the cells 10 of the array prior to programming, assuming that the pulse length is the same. As is well-known, a part of the voltage comprising the 15 or 20 volt pulses may be applied to the sources 15 or to the drains 16 prior to application of the conditioning voltage pulses to the control gates 12. As is also well-known, a fraction of the pulse energies applied between the control gates 12 and the source-drain paths of cells 10 is coupled to the floating gates 11.

The relative energy levels of the conditioning pulses, as compared to the programming and/or erasing pulses, may be controlled by current-limiting circuitry or by pulse-length circuitry, or by other means of controlling energy-related product of voltage, current and time. For example, if the pulse length of the programming, erasing and conditioning pulses is the same, it may be desirable to include circuitry in programming circuit means 18 and erasing circuit means 20 that causes the product of the current and voltage of the conditioning pulses to be less than perhaps 80% of the product of the voltage and current of the programming and/or erasing pulses. Similarly, if the same voltage or current is to be used for programming, erasing and conditioning pulses, it may be desirable to include circuitry than limits the length of the conditioning pulses to less than perhaps 80% of the length of the programming and erasing pulses. Of course, circuitry may be included to change the relative energy levels of the conditioning pulses by changing the voltage, the current and the length of the conditioning pulses such that the product of the three factors is less than perhaps 80% of the product of the three factors for the programming and/or erasing pulses.

After the cells 10 have been conditioned, individual cells may be programmed. The voltage thresholds of the programmed cells 10 will again be distributed over a range, perhaps of shape illustrated by curve B of Figure 2(a). Prior to performing the erasing operations described herein, it is better practice to program all of the cells 10 using programming circuit means 18.

While this invention has been described with respect to an illustrative embodiment, this description is not intended to be construed in a limiting sense. Upon reference to this description, various modifications of the illustrative embodiment, as well as other embodiments of the invention, will be apparent to persons skilled in the art. It is contemplated that the appended claims will cover any such modifications or embodiments that fall within the scope of the invention.

## Claims

1. A method for conditioning an EEPROM array prior to programming said array, the method comprising:
erasing the memory cells of said array by causing pulsed erasing electric fields adjacent the floating gates of each of said cells of said array, said erasing electric fields directed toward said floating gates,
characterized by conditioning all of said cells by applying pulsed conditioning electric fields adjacent parts of said floating gates of said cells, said pulsed conditioning electric fields having less field energy than the energy of pulsed electric fields used for programming or erasing said cells of said memory array.

2. The method of Claim 1 wherein said pulsed conditioning electric fields are directed away from said floating gates.

3. The method of Claim 1 wherein said pulsed conditioning electric fields are directed toward said floating gates.

4. The method of Claim 1 wherein said pulsed conditioning electric fields are alternately directed toward and away from said floating gates.

5. The method of Claim 1 wherein said pulsed conditioning electric fields are alternately directed away from and toward said floating gates.

6. The method of Claim 1 wherein all of said cells are programmed prior to erasing all of said cells.

7. The method of Claim 1 wherein the field energy of each of said pulsed conditioning electric fields is caused by a pulsed voltage applied between a wordline of said memory array and a bitline of said memory array.

8. The method of Claim 1 wherein the field energy of each of said conditioning pulsed electric fields is caused by a pulsed voltage applied between a wordline of said memory array and a bitline of said memory array and wherein the voltage of said pulsed voltage is less than 90% of the pulsed voltage used to program individual cells of said memory array.

9. The method of Claim 1 wherein the field energy of each of said pulsed conditioning electric fields is caused by a pulsed current applied between a wordline of said memory array and a bitline of said memory array.

10. The method of Claim 1 wherein the field energy of each of said pulsed conditioning electric fields is caused by a pulsed current applied between a wordline of said memory array and a bitline of said memory array and wherein the current of said pulsed current is less than 90% of the pulsed current used to program individual cells of said memory array.

11. The method of Claim 1 wherein the field energy of each of said pulsed conditioning electric fields is determined by the length of a pulsed voltage applied between a wordline of said memory array and a bitline of said memory array.

12. The method of Claim 1 wherein the field energy of each of said pulsed conditioning electric fields is determined by the length of a pulsed voltage applied between a wordline of said memory array and a bitline of said memory array and wherein the length of said pulsed voltage is less than 80% of the length of the pulsed voltage used to program individual cells of said memory array.

13. An electrically-erasable, electrically-programmable, read-only-memory array, comprising:
rows and columns of memory cells, wherein all of the memory cells in a column are connected to bitlines and wherein all of the memory cells in a row are connected to a wordline, wherein each said memory cell has charge-storing means insulated from said wordline connected to said memory cell and insulated from each of said bitlines connected to said memory cell, wherein memory storage in said cell is determined by low and high voltage thresholds between bitlines connected to said cell, and wherein an initial low voltage threshold is set during manufacture of said cell;
programming circuit means for providing programming voltages to said charge-storing means via said wordlines and bitlines;
erasing circuit means for providing erasing voltages to said charge-storing means via said wordlines and bitlines;
characterized in that said programming circuit means conditions said memory cells by applying a conditioning pulse having less energy than that of a programming pulse for programming all of said memory cells.

14. The array of Claim 13 wherein said erasing circuit means conditions said memory cells by applying a conditioning pulse having less energy than that of an erasing pulse for erasing all of said memory cells.

15. An electrically-erasable, electrically-programmable, read-only-memory array, comprising:
rows and columns of memory cells, wherein all of the memory cells in a column are connected to bitlines and wherein all of the memory cells in a row are connected to a wordline, wherein each said memory cell has charge-storing means insulated from said wordline connected to said memory cell and insulated from each of said bitlines connected to said memory cell, wherein memory storage in said cell is determined by low and high voltage thresholds between bitlines connected to said cell, and wherein an initial low voltage threshold is set during manufacture of said cell;
programming circuit means for providing programming voltages to said charge-storing means via said wordlines and bitlines;
erasing circuit means for providing erasing voltages to said charge-storing means via said wordlines and bitlines;
characterized in that said erasing circuit means conditions said memory cells by applying a conditioning pulse having less energy than that of an erasing pulse for erasing all of said memory cells.

16. The array of Claim 15 wherein said programming circuit means conditions said memory cells by applying a conditioning pulse having less energy than that of a programming pulse for programming all of said memory cells.

## Patentansprüche

1. Verfahren zum Vorbereiten ein EEPROM-Matrix vor der Programmierung der Matrix, bei welchem die Speicherzellen der Matrix gelöscht werden, indem angrenzend an die schwimmenden Gates jeder der Zellen der Matrix impulsförmige elektrische Löschfelder hervorgerufen werden, wobei die elektrischen Löschfelder zu den schwimmenden Gates hin gerichtet sind, gekennzeichnet durch ein Vorbereiten aller Zellen durch Anlegen impulsförmiger elektrischer Vorbereitungsfelder angrenzend an Teile der schwimmenden Gates der Zellen, wobei die impulsförmigen elektrischen Vorbereitungsfelder eine niedrigere Feldenergie als die Energie der impulsförmigen elektrischen Felder haben, die zum Programmieren oder Löschen der Zellen der Speichermatrix angewendet werden.

2. Verfahren nach Anspruch 1, bei welchem die impulsförmigen elektrischen Vorbereitungsfelder von den schwimmenden Gates weg gerichtet werden.

3. Verfahren nach Anspruch 1, bei welchem die impulsförmigen elektrischen Vorbereitungsfelder zu den schwimmenden Gates hin gerichtet werden.

4. Verfahren nach Anspruch 1, bei welchem die impulsförmigen elektrischen Vorbereitungsfelder abwechselnd zu den schwimmenden Gates hin und von diesen weg gerichtet werden.

5. Verfahren nach Anspruch 1, bei welchem die impulsförmigen elektrischen Vorbereitungsfelder abwechselnd von den schwimmenden Gates weg und zu diesen hin gerichtet werden.

6. Verfahren nach Anspruch 1, bei welchem alle Zellen vor dem Löschen aller Zellen programmiert werden.

7. Verfahren nach Anspruch 1, bei welchem die Feldenergie jedes der impulsförmigen elektrischen Vorbereitungsfelder durch eine impulsförmige Spannung hervorgerufen wird, die zwischen eine Wortleitung der Speichermatrix und eine Bitleitung der Speichermatrix angelegt wird.

8. Verfahren nach Anspruch 1, bei welchem die Feldenergie jedes der impulsförmigen elektrischen Vorbereitungsfelder durch eine impulsförmige Spannung hervorgerufen wird, die zwischen eine Wortleitung der Speichermatrix und eine Bitleitung der Speichermatrix angelegt wird, und bei welchem der Wert der impulsförmigen Spannung kleiner als 90 % der impulsförmigen Spannung ist, die zum Programmieren einzelner Zellen der Speichermatrix benutzt wird.

9. Verfahren nach Anspruch 1, bei welchem die Feldenergie jedes der impulsförmigen elektrischen Vorbereitungsfelder durch einen impulsförmigen Strom hervorgerufen wird, der zwischen eine Wortleitung der Speichermatrix und eine Bitleitung der Speichermatrix angelegt wird.

10. Verfahren nach Anspruch 1, bei welchem die Feldenergie jedes der impulsförmigen elektrischen Vorbereitungsfelder durch einen impulsförmigen Strom hervorgerufen wird, der zwischen eine Wortleitung der Speichermatrix und eine Bitleitung der Speichermatrix angelegt wird, und bei welcher der Wert des impulsförmigen Stroms kleiner als 90 % des impulsförmigen Stroms ist, der zum Programmieren einzelner Zellen der Speichermatrix benutzt wird.

11. Verfahren nach Anspruch 1, bei welchem die Feldenergie jedes der impulsförmigen elektrischen Vorbereitungsfelder durch die Dauer einer impulsförmigen Spannung bestimmt wird, die zwischen einer Wortleitung der Speichermatrix und einer Bitleitung der Speichermatrix angelegt wird.

12. Verfahren nach Anspruch 11, bei welchem die Feldenergie jedes der impulsförmigen elektrischen Vorbereitungsfelder durch die Dauer einer impulsförmigen Spannung bestimmt wird, die zwischen einer Wortleitung der Speichermatrix und einer Bitleitung der Speichermatrix angelegt wird, und bei welchem die Dauer der impulsförmigen Spannung kleiner als 80 % der Dauer der impulsförmigen Spannung ist, die zum Programmieren einzelner Zellen der Speichermatrix benutzt wird.

13. Elektrisch löschbare, elektrisch programmierbare Festspeichermatrix, enthaltend:
Speicherzellenzeilen und -spalten, wobei alle Speicherzellen in einer Spalte an Bitleitungen und alle Speicherzellen in einer Zeile an eine Wortleitung angeschlossen sind, wobei jede Speicherzelle Ladungsspeichermittel aufweist, die von der mit der Speicherzelle verbundenen Wortleitung und von jeder der mit der Speicherzelle verbundenen Bitleitungen isoliert sind, wobei die Speicherung in der Zelle durch niedrige und hohe Spannungsschwellenwerte zwischen Bitleitungen bestimmt wird, die mit der Zelle verbunden sind, und wobei ein anfänglicher niedriger Spannungsschwellenwert während der Herstellung der Zelle eingestellt wird;
Programmierschaltungsmittel zum Zuführen von Programmierspannungen an die Ladungsspeichermittel über die Wortleitungen und die Bitleitungen;
Löschschaltungsmittel zum Zuführen von Löschspannungen an die Ladungsspeichermittel über die Wortleitungen und die Bitleitungen;
dadurch gekennzeichnet, daß die Programmierschaltungsmittel die Speicherzellen dadurch vorbereiten, daß ein Vorbereitungsimpuls angelegt wird, der eine geringere Energie als ein Programmierimpuls zum Programmieren aller Speicherzellen hat.

14. Matrix nach Anspruch 13, bei welcher die Löschschaltungsmittel die Speicherzellen dadurch vorbereiten, daß ein Vorbereitungsimpuls angelegt wird, der eine niedrigere Energie als ein Löschimpuls zum Löschen aller Speicherzellen hat.

15. Elektrisch löschbare, elektrisch programmierbare Festspeichermatrix, enthaltend:
Speicherzellenzeilen und -spalten, wobei alle Speicherzellen in einer Spalte an Bitleitungen und alle Speicherzellen in einer Zeile an eine Wortleitung angeschlossen sind, wobei jede Speicherzelle Ladungsspeichermittel aufweist, die von der mit der Speicherzelle verbundenen Wortleitung und von jeder der mit der Speicherzelle verbundenen Bitleitungen isoliert sind, wobei die Speicherung in der Zelle durch niedrige und hohe Spannungsschwellenwerte zwischen Bitleitungen bestimmt wird, die mit der Zelle verbunden sind, und wobei ein anfänglicher niedriger Spannungsschwellenwert während der Herstellung der Zelle eingestellt wird;
Programmierschaltungsmittel zum Zuführen von Programmierspannungen an die Ladungsspeichermittel über die Wortleitungen und die Bitleitungen;
Löschschaltungsmittel zum Zuführen von Löschspannungen an die Ladungsspeichermittel über die Wortleitungen und die Bitleitungen;
dadurch gekennzeichnet, daß die Löschschaltungsmittel die Speicherzellen dadurch vorbereiten, daß ein Vorbereitungsimpuls angelegt wird, der eine niedrigere Energie als ein Löschimpuls zum Löschen aller Speicherzellen hat.

16. Matrix nach Anspruch 15, bei welcher die Programmierschaltungsmittel die Speicherzellen dadurch vorbereiten, daß ein Vorbereitungsimpuls angelegt wird, der eine niedrigere Energie als ein Programmierimpuls zum Programmieren aller Speicherzellen hat.

## Revendications

1. Procédé pour le conditionnement d'un réseau d'EEPROM avant la programmation dudit réseau, le procédé comprenant les étapes consistant à :
effacer les cellules mémoire dudit réseau en provoquant des champs électriques d'effacement impulsionnels adjacents aux grilles flottantes de chacune desdites cellules dudit réseau, lesdits champs électriques d'effacement étant dirigés vers lesdites grilles flottantes,
caractérisé par le conditionnement de toutes lesdites cellules en appliquant des champs électriques de conditionnement impulsionnels adjacents aux parties desdites grilles flottantes desdites cellules, lesdits champs électriques de conditionnement impulsionnels ayant une énergie de champ inférieure à l'énergie des champs électriques impulsionnels utilisés pour la programmation ou l'effacement desdites cellules dudit réseau de mémoire.

2. Procédé selon la revendication 1, dans lequel lesdits champs électriques de conditionnement impulsionnels sont dirigés à l'opposé desdites grilles flottantes.

3. Procédé selon la revendication 1, dans lequel lesdits champs électriques de conditionnement impulsionnels sont dirigés vers lesdites grilles flottantes.

4. Procédé selon la revendication 1, dans lequel lesdits champs électriques de conditionnement impulsionnels sont alternativement dirigés vers lesdites grilles flottantes et à l'opposé desdites grilles flottantes.

5. Procédé selon la revendication 1, dans lequel lesdits champs électriques de conditionnement impulsionnels sont alternativement dirigés à l'opposé desdites grilles flottantes et vers lesdites grilles flottantes.

6. Procédé selon la revendication 1, dans lequel toutes lesdites cellules sont programmées avant l'effacement de toutes lesdites cellules.

7. Procédé selon la revendication 1, dans lequel l'énergie de champ de chacun desdits champs électriques de conditionnement impulsionnels est provoquée par une impulsion de tension appliquée entre une ligne de mots dudit réseau de mémoire.

8. Procédé selon la revendication 1, dans lequel l'énergie de champ de chacun desdits champs éléctriques de conditionnement impulsionnels est provoquée par une impulsion de tension appliquée entre une ligne de mots dudit réseau de mémoire et une ligne de bits dudit réseau de mémoire et dans lequel la tension de ladite impulsion de tension est inférieure à 90% de l'impulsion de tension utilisée pour programmer les cellules individuelles dudit réseau de mémoire.

9. Procédé selon la revendication 1, dans lequel l'énergie de champ de chacun desdits champs électriques de conditionnement impulsionnels est provoquée par une impulsion de courant appliquée entre une ligne de mots dudit réseau de mémoire et une ligne de bits dudit réseau de mémoire.

10. Procédé selon la revendication 1, dans lequel l'énergie de champ de chacun desdits champs électriques de conditionnement impulsionnels est provoquée par une impulsion de courant appliquée entre une ligne de mots dudit réseau de mémoire et une ligne de bits dudit réseau de mémoire et dans lequel le courant de ladite impulsion de courant est inférieur à 90% de l'impulsion de courant utilisé pour programmer les cellules individuelles dudit réseau de mémoire.

11. Procédé selon la revendication 1, dans lequel l'énergie de champ de chacun desdits champs électriques de conditionnement impulsionnel est déterminée par la longueur d'une impulsion de tension appliquée entre une ligne de mots dudit réseau de mémoire et une ligne de bits dudit réseau de mémoire.

12. Procédé selon la revendication 1, dans lequel l'énergie de champ de chacun desdits champs électriques de conditionnement impulsionnels est déterminée par la longueur d'une impulsion de tension appliquée entre une ligne de mots dudit réseau de mémoire et une ligne de bits dudit réseau de mémoire et dans lequel la longueur de ladite impulsion de tension est inférieure à 80% de la longueur de l'impulsion de tension utilisée pour programmer les cellules individuelles dudit réseau de mémoire.

13. Réseau de mémoire morte électriquement programmable, électriquement effaçable, comprenant :
des lignes et des colonnes de cellules mémoire, dans lesquelles toutes les cellules mémoire d'une colonne sont connectées à des lignes de bits et dans lesquelles toutes les cellules mémoire dans une rangée sont reliées à une ligne de mots, dans lequel chacune desdites cellules mémoire comporte des moyens de stockage de charge isolés de ladite ligne de mots reliée à ladite cellule mémoire et isolés de chacune desdites lignes de bits reliées à ladite cellule mémoire, dans lequel le stockage en mémoire dans ladite cellule est déterminé par des seuils de tension bas et haut entre des lignes de bits reliées à ladite cellule, et dans lequel un seuil de tension bas initial est positionné durant la fabrication de ladite cellule ;
des moyens de circuit de programmation pour fournir des tensions de programmation auxdits moyens de stockage de charge par l'intermédiaire desdites lignes de mots et lignes de bits ;
des moyens de circuit d'effacement pour fournir des tensions d'effacement auxdits moyens de stockage de charge par l'intermédiaire desdites lignes de mots et desdites lignes de bits ;
caractérisé en ce que lesdits moyens de circuit de programmation conditionnent lesdites cellules mémoire en appliquant une impulsion de conditionnement ayant une énergie inférieure à celle d'une impulsion de programmation pour programmer toutes lesdites cellules mémoires.

14. Réseau selon la revendication 13, dans lequel lesdits moyens de circuit d'effacement conditionnent lesdites cellules mémoire en appliquant une impulsion de conditionnement ayant une énergie inférieure à celle d'une impulsion d'effacement pour effacer toutes lesdites cellules mémoire.

15. Réseau de mémoire morte, électriquement programmable, électriquement effaçable comprenant :
des rangées et des colonnes de cellules mémoire, dans lesquelles toutes les cellules mémoire d'une colonne sont reliées à des lignes de bits et dans lesquelles toutes les cellules mémoire d'une rangée sont reliées à une ligne de mots, dans lequel chacune desdites cellules mémoire comporte des moyens de stockage de charge isolés de ladite ligne de mots reliée à ladite cellule mémoire et isolés de chacune desdites lignes de bits reliées à ladite cellule mémoire, dans lequel le stockage en mémoire dans ladite cellule est déterminé par des seuils de tension bas et haut entre les lignes de bits reliées à ladite cellule, et dans lequel un seuil de tension bas initial est positionné pendant la fabrication de ladite cellule ;
des moyens de circuit de programmation pour fournir des tensions de programmation auxdits moyens de stockage de charge par l'intermédiaire desdites lignes de mots et lignes de bits ;
des moyens de circuit d'effacement pour fournir des tensions d'effacement auxdits moyens de stockage de charge par l'intermédiaire des lignes de mots et des lignes de bits ;
caractérisé en ce que lesdits moyens de circuit d'effacement conditionnent lesdites cellules mémoire en appliquant une impulsion de conditionnement ayant une énergie inférieure à celle d'une impulsion d'effacement pour effacer toutes lesdites cellules mémoire.

16. Réseau selon la revendication 15, dans lequel lesdits moyens de circuit de programmation conditionnent lesdites cellules mémoire en appliquant une impulsion de conditionnement ayant une énergie inférieure à celle d'une impulsion de programmation pour programmer toutes lesdites cellules mémoire.
